# EUROPEAN PATENT APPLICATION

(11) **EP 4 398 695 A1**
(43) Date of publication of application: **10.07.2024**
(21) Application number: 23196807.4
(22) Date of filing: 12.09.2023
(51) Int. Cl.: H10B 43/27

(54) **VERTICAL NON-VOLATILE MEMORY DEVICE AND ELECTRONIC APPARATUS INCLUDING THE SAME**

(30) Priority: 04.01.2023 KR 20230001321
(71) Applicant: Samsung Electronics Co., Ltd., Suwon-si, Gyeonggi-do 16677 (KR)
(72) Inventor: HEO, Hoseok, 16678 Suwon-si (KR); KIM, Hyungyung, 16678 Suwon-si (KR); HYUN, Seungdam, 16678 Suwon-si (KR); KIM, Kyunghun, 16678 Suwon-si (KR); YANG, Seungyeul, 16678 Suwon-si (KR); YON, Gukhyon, 16678 Suwon-si (KR); LEE, Minhyun, 16678 Suwon-si (KR); CHOI, Seokhoon, 16678 Suwon-si (KR)
(74) Representative: Elkington and Fife LLP

(57) **Abstract**

A vertical non-volatile memory device and an electronic apparatus including the vertical non-volatile memory device are provided. The vertical non-volatile memory device includes a pillar, a channel layer surrounding a side surface of the pillar, a charge tunneling layer surrounding a side surface of the channel layer, a charge trap layer surrounding a side surface of the charge tunneling layer and including an amorphous oxynitride, a charge blocking layer surrounding a side surface of the charge trap layer, and a plurality of separation layers and a plurality of gate electrodes surrounding a side surface of the charge blocking layer and alternately arranged along the side surface of the charge blocking layer.

## Description

### FIELD OF THE INVENTION

The disclosure relates to vertical non-volatile memory devices and/or electronic apparatuses including the vertical non-volatile memory device.

### BACKGROUND OF THE INVENTION

A non-volatile memory device includes a plurality of memory cells which retain data even when power thereto is blocked, and thus, are able to use the stored data when power is supplied again. A non-volatile memory device may be used in a cellular phone, a digital camera, a portable digital assistant (PDA), a mobile computer device, a stationary computer device, and other devices.

In order to increase the capacity of a non-volatile memory device, it is necessary to prevent charge diffusion or leakage between cells.

### SUMMARY OF THE INVENTION

Provided are vertical non-volatile memory devices with a reduced charge diffusion or leakage between cells and electronic apparatuses including the vertical non-volatile memory device.

Additional aspects will be set forth in part in the description which follows and, in part, will be apparent from the description, or may be learned by practice of the presented example embodiments of the disclosure.

According to an aspect of the disclosure, a vertical non-volatile memory device may include a pillar, a channel layer surrounding a side surface of the pillar, a charge tunneling layer surrounding a side surface of the channel layer, a charge trap layer surrounding a side surface of the charge tunneling layer and including an amorphous oxynitride, a charge blocking layer surrounding a side surface of the charge trap layer, and a plurality of separation layers and a plurality of gate electrodes surrounding a side surface of the charge blocking layer and alternately arranged along the side surface of the charge blocking layer.

The charge trap layer may include AxByOzN (1-x-y-z) (A and B are different elements, and at least one of A or B is a metal element, O is oxygen, N is nitrogen, x≥0.3, 0<y≤0.1, z≥x).

The A element may be any one of aluminum (Al), hafnium (Hf), zirconium (Zr), and silicon (Si).

The B element may be any one of aluminum (Al), hafnium (Hf), zirconium (Zr), silicon (Si), boron (B), and gallium (Ga).

The content of the A element in the charge trap layer may be about 40 at% or less.

The content of the oxygen element in the charge trap layer may be about 60 at% or less.

The content of the B element in the charge trap layer may be about 6 at% or less.

The charge trap layer may further include carbon.

The content of carbon may be less than or equal to a content of nitrogen in the charge trap layer.

The content of carbon in the charge trap layer may be about 6 at% or less.

The density of the A element may change in a thickness direction of the charge trap layer.

The charge trap layer may include a region in which a density of the B element is greater than or equal to the density of the A element in the thickness direction of the charge trap layer.

The density of the A element may be greater than a density of B element at an interface of the charge trap layer in contact with the charge tunneling layer.

The density of the A element may be greater than a density of B element at an interface of the charge trap layer in contact with the charge blocking layer.

The trap level of the charge trap layer may be about 1.2 eV or more.

The trap density of the charge trap layer may be in a range between about 18×10¹⁸/cm² and about 30×10¹⁸/cm².

The dielectric constant of the charge trap layer may be equal to or greater than 9.

The charge trap layer may include a nanocrystal of about 10 at% or less.

The nanocrystal may have a diameter in a range between about 0.5 nm and about 5 nm.

The thickness of the charge trap layer may be in a range between about 5 nm and about 30 nm.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view showing a schematic structure of a vertical non-volatile memory device according to an example embodiment;
FIG. 2 is a perspective view illustrating a schematic structure of a memory string included in the vertical non-volatile memory device of FIG. 1;
FIG. 3 is an equivalent circuit of a memory device including the vertical non-volatile memory device of FIG. 1;
FIG. 4 is a diagram illustrating a vertical non-volatile memory device including a charge trap layer that appears as a single layer according to an example embodiment;
FIG. 5A is a diagram showing an image and a Fourier transform pattern obtained by forming a charge trap layer including aluminum oxynitride and then analyzing a result of heat treatment thereon using a transmission electron microscope, according to a comparative example;
FIG. 5B is a diagram showing an image and a Fourier transform pattern obtained by forming a charge trap layer including aluminum oxynitride and hafnium nitride and then analyzing a result of heat treatment thereon using a transmission electron microscope;
FIG. 6A is a graph showing X-ray diffraction analysis according to a material of a charge trap layer at a small thickness according to an example embodiment;
FIG. 6B is a graph showing X-ray diffraction analysis according to a material of a charge trap layer at a great thickness according to an example embodiment;
FIG. 7A is a graph showing an energy band when a charge trap layer includes silicon oxynitride according to a comparative example;
FIG. 7B is a graph showing an energy band when a charge trap layer includes hafnium nitride in addition to silicon oxynitride according to an example embodiment;
FIGS. 8A to 8G are reference views illustrating a method of manufacturing a vertical non-volatile memory device according to an example embodiment;
FIG. 9 is a schematic block diagram illustrating a display driver IC (DDI) and a display apparatus including the DDI according to an example embodiment;
FIG. 10 is a block diagram illustrating an electronic apparatus according to an example embodiment;
FIG. 11 is a block diagram illustrating an electronic apparatus according to an example embodiment;
FIG. 12 is a conceptual diagram schematically illustrating a device architecture applicable to an electronic apparatus according to an example embodiment; and
FIG. 13 is a conceptual diagram schematically illustrating a device architecture applicable to an electronic apparatus according to another example embodiment.

### DETAILED DESCRIPTION

Reference will now be made in detail to some example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The phrases "in some example embodiments" or "in an example embodiment" appearing in various places in the specification may not necessarily all refer to the same embodiment.

Some example embodiments of the disclosure may be represented in terms of functional block components and various processing operations. Some or all of these functional blocks may be implemented by any number of hardware and/or software components that execute particular functions. For example, the functional blocks of the disclosure may be implemented by one or more microprocessors or may be implemented by circuit components for a certain function. Also, for example, the functional blocks of the disclosure may be implemented in various programming or scripting languages. The functional blocks may be implemented by an algorithm that is executed in one or more processors. Also, the disclosure may employ the related art for electronic environment setting, signal processing, and/or data processing. Terms such as "mechanism," "element," "unit," and "configuration" may be used in a broad sense, and are not limited to mechanical and physical configurations.

Also, connection lines or connection members between components illustrated in the drawings are merely examples of functional connections and/or physical or logical connections. In an actual apparatus, connections between components may be represented by various functional connections, physical connections, or logical connections that may be replaced or added.

The term such as "comprise" or "include" used herein should not be construed as necessarily including all of the elements or operations described herein, and should be construed as not including some of the described elements or operations or as further including additional elements or operations.

As used herein, the term "over" or "on" may include not only "directly over" or "directly on" but also "indirectly over" or "indirectly on".

Expressions such as "at least one of," when preceding a list of elements, modify the entire list of elements and do not modify the individual elements of the list. For example, an expression such as "at least one of A, B, and C" or "at least one selected from the group consisting of A, B, and C" may be interpreted as only A, only B, only C, or any combination of two or more of A, B, and C, such as A, B, and C, A and B, B and C, and A and C.

When the term "about" or "substantially" is used in relation to a numerical value, the numerical value may be interpreted as including manufacturing or operating deviations (e.g., ±10 %) around the numerical value. Also, when the term "generally" or "substantially" is used in relation to a geometric shape, it may be intended that a geometric accuracy is not required and a tolerance of the shape is within the scope of the present example embodiments. Also, regardless of whether a numerical value or a shape is modified by the term "about" or "substantially," the numerical value or the shape may be interpreted as including manufacturing or operating deviations (e.g., ±10 %) around the numerical value or the shape.

Although terms such as "first" and "second" may be used herein to describe various elements or components, these elements or components should not be limited by these terms. These terms are only used to distinguish one element or component from another element or component.

Hereinafter, some example embodiments of the disclosure will be described in detail merely as examples with reference to the accompanying drawings.

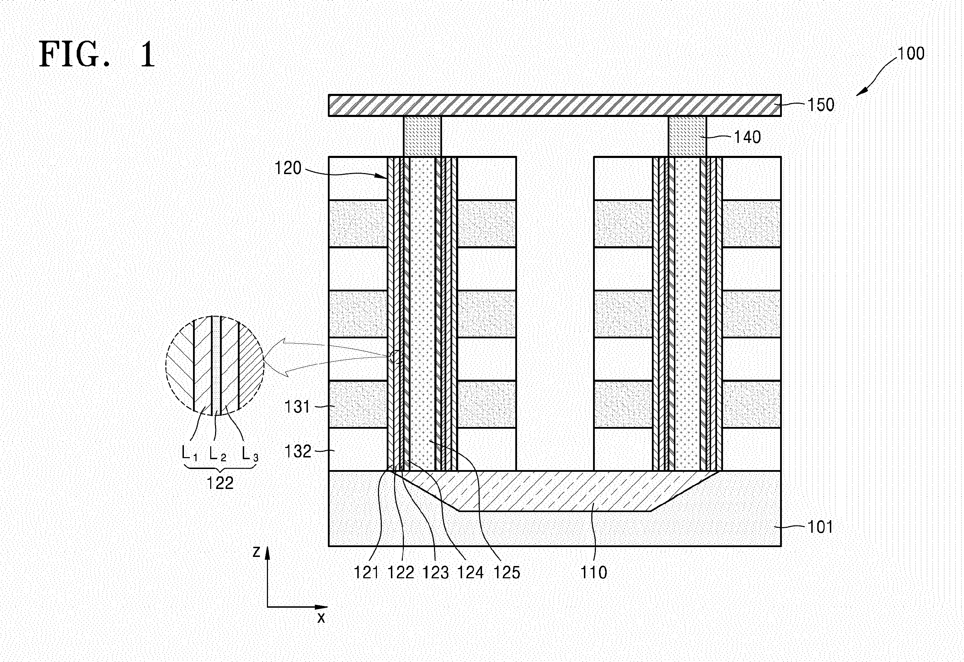

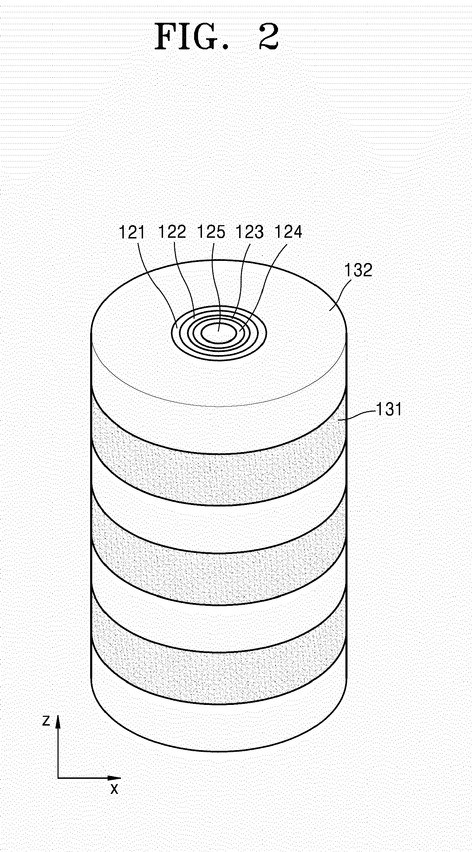

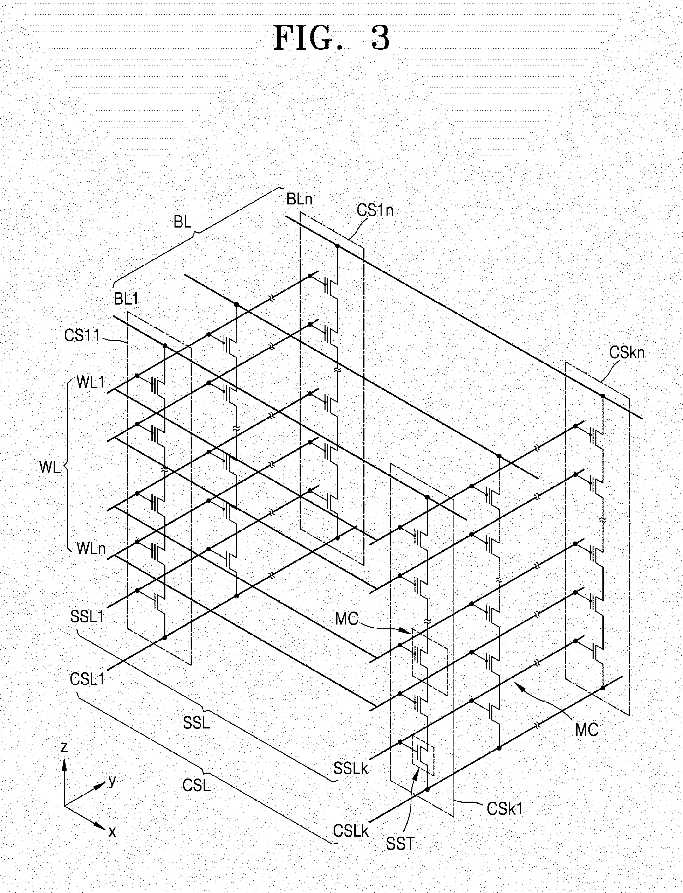

FIG. 1 is a cross-sectional view showing a schematic structure of a vertical non-volatile memory device 100 according to an example embodiment, FIG. 2 is a schematic structure of a memory string included in the vertical non-volatile memory device 100 of FIG. 1, and FIG. 3 is an equivalent circuit of a memory device including the vertical non-volatile memory device 100 of FIG. 1.

First, referring to FIGS. 1 and 2, a plurality of cell strings CS are formed on a substrate 101.

The substrate 101 may include a first type impurity-doped silicon material. For example, the substrate 101 may include a p-type impurity-doped silicon material. For example, substrate 101 may be a p-type well (e.g., a pocket p-well). Hereinafter, it is assumed that the substrate 101 is p-type silicon. However, the substrate 101 is not limited to p-type silicon.

A common source region 110 is provided on the substrate 101. For example, the common source region 110 may have a second type different from that of the substrate 101. For example, the common source region 110 may have an n-type. Hereinafter, it is assumed that the common source region 110 is n-type. However, the common source region 110 is not limited to being n-type. The common source region 110 may be connected to a common source line CSL.

As shown in the circuit diagram of FIG. 3, k*n cell strings CS may be provided and arranged in a matrix form, and may be named as CSij (1≤i≤k, 1≤j≤n) according to positions of each row and column. Each cell string CSij is connected to a bit line 150 BL, a string selection line SSL, a word line WL, and the common source line CSL.

Each cell string CSij includes memory cells MC and a string selection transistor SST. The memory cells MC and the string selection transistor SST of each cell string CSij may be stacked in a height direction.

Rows of the plurality of cell strings CS are connected to different string selection lines SSL1 to SSLk, respectively. For example, the string selection transistors SST of cell strings CS11 to CS1n are commonly connected to the string selection line SSL1. The string selection transistors SST of cell strings CSk1 to CSkn are commonly connected to the string selection line SSLk.

Columns of the plurality of cell strings CS are connected to different bit lines BL1 to BLn, respectively. For example, the memory cells MC and the string selection transistors SST of the cell strings CS11 to CSk1 may be commonly connected to the bit line 150 BL1, and the memory cells MC and the string selection transistors SST of the cell strings CS1n to CSkn may be commonly connected to the bit line BLn.

Rows of the plurality of cell strings CS may be connected to different common source lines CSL1 to CSLk, respectively. For example, the string selection transistors SST of the cell strings CS11 to CS1n may be commonly connected to the common source line CSL1, and the string selection transistors SST of the cell strings CSk1 to CSkn may be commonly connected to the common source line CSLk.

The memory cells MC located at the same height from the substrate 101 or the string selection transistors SST may be commonly connected to one word line WL, and the memory cells MC located at different heights from the substrate 101 or the string selection transistors SST may be connected to different word lines WL1 to WLm, respectively.

The circuit structure shown is an example. For example, the number of rows of the cell strings CS may increase or decrease. As the number of rows of the cell string CS changes, the number of string selection lines connected to the rows of the cell string CS and the number of cell strings CS connected to one bit line 150 may also change. As the number of rows of the cell strings CS changes, the number of common source lines connected to the rows of the cell strings CS may also change.

The number of columns of the cell strings CS may also increase or decrease. As the number of columns of the cell string CS changes, the number of bit lines 150 connected to the columns of the cell strings CS and the number of cell strings CS connected to one string selection line may also change.

The height of the cell string CS may also increase or decrease. For example, the number of memory cells MC stacked on each cell string CS may increase or decrease. As the number of memory cells MC stacked on each cell string CS changes, the number of word lines WL may also change. For example, the number of string selection transistors provided in each of the cell strings CS may increase. As the number of string selection transistors provided in each of the cell strings CS changes, the number of string selection lines or common source lines may also change. When the number of string selection transistors increases, the string selection transistors may be stacked in the same form as the memory cells MC.

For example, writing and reading may be performed in units of rows of cell strings CS. The cell strings CS may be selected in units of one row by the common source line CSL, and the cell strings CS may be selected in units of one row by the string selection lines SSL. Also, voltage may be applied to the common source lines CSL in units of at least two common source lines. The voltage may be applied to the common source lines CSL in units of all common source lines.

In the selected row of the cell strings CS, writing and reading may be performed in units of pages. A page may be one row of memory cells MC connected to one word line WL. In the selected row of cell strings CSs, the memory cells MC may be selected in units of pages by the word lines WL.

Referring back to FIGS. 1 and 2, the cell string CS includes a cylindrical channel hole 120, a plurality of gate electrodes 131 and a plurality of separation layers 132 surrounding the cylindrical channel hole 120 in a ring shape. The plurality of gate electrodes 131 and the plurality of separation layers 132 may be alternately stacked with each other in a vertical direction (Z direction).

The gate electrode 131 may include a metal material or a highly doped silicon material. Each gate electrode 131 is connected to a corresponding one of the word line WL and the string selection line SSL.

The separation layer 132 may serve as a spacer for insulation between conductive layers. The separation layer 132 may include various insulating materials (e.g., silicon oxide or silicon nitride).

A channel hole 120 passes through each of the gate electrode 131 and the separation layer 132. Here, the channel hole 120 may extend in a direction (e.g., the z-axis direction in FIG. 2) perpendicular to the surface of the substrate 101. The channel hole 120 may have a circular cross section.

A plurality of layers may be provided in the channel hole 120. On the inner wall of the channel hole 120, a charge blocking layer 121, a charge trap layer 122, a charge tunneling layer 123, a channel layer 124, and a pillar 125 are provided sequentially. Here, when a certain voltage is applied to the gate electrode 131, charges flowing in the channel layer 124 may pass through the charge tunneling layer 123 and be trapped in the charge trap layer 122 so that information may be stored.

Each of the charge blocking layer 121, the charge trap layer 122, and the charge tunneling layer 123 may extend in a direction perpendicular to the surface of the substrate 101. Each of the charge blocking layer 121, the charge trap layer 122, and the charge tunneling layer 123 may have a cylindrical shape.

The charge blocking layer 121 may be provided on the inner wall of the channel hole 120 to contact the gate electrode 131 and the separation layer 132. The charge blocking layer 121 may perform a barrier function of blocking charge transfer between the charge trap layer 122 and the gate electrode 131. A first surface of the charge blocking layer 121 may contact the charge trap layer 122, and a second surface facing the first surface may contact the gate electrode 131. The charge blocking layer 121 may include, for example, silicon oxide or metal oxide, but is not limited thereto.

The charge trap layer 122 may store introduced charges. Charges (e.g., electrons) existing in the channel layer 124 may be introduced into the charge trap layer 122 by a tunneling effect. Charges introduced into the charge trap layer 122 may be fixed to the charge trap layer 122. The charge trap layer 122 may include amorphous oxynitride. The charge trap layer 122 is described below.

The charge tunneling layer 123 is a layer through which charges are tunneled, and may include, for example, silicon oxide or metal oxide, but is not limited thereto.

The channel layer 124 may include a first type doped semiconductor material. The channel layer 124 may include the same type doped silicon material as that of the substrate 101. For example, when the substrate 101 includes a p-type doped silicon material, the channel layer 124 may also include the p-type doped silicon material. In some example embodiments, the channel layer 124 may include a material such as Ge, IGZO, or GaAs. The channel layer 124 may have a cylindrical shape.

The pillar 125 may be disposed inside the channel layer 124. The pillar 125 may include, for example, silicon oxide or air, but is not limited thereto.

The channel layer 124 may contact a doped region, that is, the common source region 110.

A drain 140 may be provided on the channel hole 120. The drain 140 may include a second type doped silicon material. For example, the drain 140 may include an n-type doped silicon material.

On the drain 140, the bit line 150 may be provided. The drain 140 and the bit line 150 may be connected to each other through contact plugs.

Each gate electrode 131 and the separation layer 132 and the channel layer 124 facing the gate electrode 131 in a horizontal direction (X direction) constitute the memory cell MC. That is, the memory cell MC has a circuit structure in which a transistor including the gate electrode 131, the separation layer 132, and the channel layer 124 is connected to the charge trap layer 122.

These memory cells MC are continuously arranged in a vertical direction (Z direction) to constitute the cell string CS. Also, as shown in the circuit diagram of FIG. 3, both ends of the cell string CS may be connected to the common source line CSL and the bit line BL, respectively. By applying voltage to the common source line CSL and the bit line BL, program, read, and erase processes may be performed on the plurality of memory cells MC.

For example, when the memory cell MC to be written is selected, a gate voltage value of a selected cell is adjusted so that no channel is formed in the selected cell, that is, a channel is off, and gate voltage values of unselected cells are adjusted so that the channel is on in the unselected cells. Accordingly, charges are tunneled through the charge tunneling layer 123 by the voltage applied to the common source line CSL and the bit line BL, and are stored in the charge trap layer 122 of the selected memory cell MC, and thus, desired information of 1 or 0 may be written in the selected memory cell MC.

In a read operation, similarly, reading may be performed on the selected cell. That is, a cell state (1 or 0) may be confirmed by adjusting the gate voltage applied to each gate electrode 131 so that the selected memory cell MC is in a channel-off state and the unselected memory cells are in a channel-on state, and then, measuring current flowing in the memory cell MC by an applied voltage Vread between the common source line CSL and the bit line BL.

The vertical non-volatile memory device 100 has a structure in which cells are connected in a vertical direction. When information is stored, charges may diffuse in the vertical direction and move to adjacent cells, and thus, the operation of adjacent cells may be affected.

The charge trap layer 122 according to an example embodiment may have a high permittivity and a high trap density. A permittivity of the charge trap layer 122 may be in a range between about 9 and about 20. In some example embodiments, a permittivity of the charge trap layer 122 may be about 9, about 12, or about 20. A trap level of the charge trap layer 122 may be about 1.2 eV, about 1.5 eV, about 2 eV, or about 3 eV or less. A trap density of the charge trap layer 122 may be in a range between about 16×10¹⁸/cm² and about 30×10¹⁸/cm². In some example embodiments, A trap density of the charge trap layer 122 may be about 16×10¹⁸/cm², about 18×10¹⁸/cm², about 20×10¹⁸/cm², about 24×10¹⁸/cm², about 26×10¹⁸/cm², about 28×10¹⁸/cm², or about 30×10¹⁸/cm². The charge trap layer 122 may have an enhanced electric field effect due to its high permittivity, and may have an improved charge storage efficiency due to its high charge storage density.

The charge trap layer 122 may include a quaternary or higher material to increase a trap site. For example, the charge trap layer 122 may include a matrix material having a high trap density and a crystallization control material controlling crystallization of the matrix material. The content of the matrix material in the charge trap layer 122 may be dominant as 80 at% or more, 85 at% or more, 90 at% or more, or 95 at% or more. The content of the crystallization control material in the charge trap layer 122 may be 20 at% or less, 15 at% or less, 10 at% or less, or 5 at% or less.

The matrix material may include oxynitride. For example, the matrix material may include at least one of aluminum oxynitride or silicon oxynitride. The matrix material may include oxide as well as nitride, and may implement low formation energy and deep trap charge state while having an intrinsic defect due to nitrogen vacancy.

In a process of manufacturing the vertical non-volatile memory device 100, the matrix material may be crystallized by heat treatment. When the charge trap layer 122 is crystallized, a defect may occur due to a grain boundary, and charge leakage may occur due to the defect. In addition, a dielectric property of the charge trap layer 122 may deteriorate due to the defect described above.

For example, a crystal grain of a nanostructure such as aluminum nitride (AIN) may be locally generated in the charge trap layer 122 including aluminum oxynitride due to heat treatment. This acts as a limit to increasing the trap density. Therefore, even though the charge trap layer 122 is heat-treated, it is desired to include a material capable of suppressing crystallization and increasing the trap density.

The crystallization control material according to an example embodiment may be a material having a high critical crystallization temperature. The crystallization control material may have a higher critical crystallization temperature than the matrix material. For example, a critical crystallization temperature of the crystallization control material may be about 1000 °C or higher. The crystallization control material may include at least one of hafnium nitride, aluminum nitride, boron nitride, gallium nitride, silicon oxide, aluminum oxide, magnesium oxide, zirconium carbide, hafnium carbide, silicon carbide, or aluminum carbide.

The charge trap layer 122 according to an example embodiment includes the crystallization control material, and thus, even when heat is applied to the charge trap layer 122, the material of the charge trap layer 122 is not crystallized and maintains an amorphous state, thereby improving the thermal stability of charge trap layer 122. Further, a new type of defect is additionally generated by the crystallization control material, which improves a defect density, thereby reducing charge leakage and enhancing dielectric property.

The charge trap layer 122 may include nanocrystals. The content of nanocrystals in the charge trap layer 122 may be small. The nanocrystals may be spherical or ellipsoidal, and may not be connected to each other because the nanocrystals are all surrounded by the matrix material in the charge trap layer 122. Thus, the nanocrystals described above do not induce a charge transfer. For example, the content of nanocrystals in the charge trap layer 122 may be 10 at% or less, 7 at% or less, 5 at% or less, or 3 at% or less. The nanocrystals may have a diameter in a range of about 0.5 nm and about 5 nm. In some example embodiments, a diameter of the nanocrystals may be about 1 nm, about 2 nm, about 3 nm, about 4 nm, or about 5 nm.

In order to include the nanocrystals, the charge trap layer 122 may include a crystallization control material having a low critical crystallization temperature. The crystallization control material may have a lower critical crystallization temperature than the matrix material. For example, the crystallization control material may include at last one of hafnium oxide, zirconium oxide, indium oxide, zinc oxide, gallium oxide, yttrium oxide, barium oxide, tantalum oxide, strontium oxide, or scandium oxide.

The content of the crystallization control material having a low critical crystallization temperature may be smaller than the content of the crystallization control material having a high critical crystallization temperature. For example, the crystallization control material having the low critical crystallization temperature with respect to the crystallization control material having the high critical crystallization temperature may be about 30 at% or less (e.g., 0 at%, about 5 at%, about 10 at%, about 15 at%, about 25 at%, or about 30 at%).

The charge trap layer 122 according to an example embodiment may have a multilayer structure. For example, the charge trap layer 122 may include a first layer L₁ constituting the matrix material, a second layer L₂ constituting the crystallization control material, and a third layer L₃ constituting the matrix material. The first to third layers L₁, L₂, and L₃ may be sequentially arranged in a direction from the charge blocking layer 121 to the charge tunneling layer 123. That is, the first layer L₁ may contact the charge blocking layer 121 and the third layer L₃ may contact the charge tunneling layer 123. Thus, the density of the matrix material may be greater than the density of the crystallization control material on the interface of the charge trap layer 122 contacting the charge blocking layer 121 and the interface of the charge trap layer 122 contacting the charge tunneling layer 123.

The density of the crystallization control material may vary in the thickness direction of the charge trap layer 122. That is, when the charge trap layer 122 includes the first to third layers L₁, L₂, and L₃, the density of the crystallization control material may be greatest in the second layer L₂.

The first and third layers L₁ and L₃ may include the same material or different materials. For example, the first and third layers L₁ and L₃ may include aluminum oxynitride, silicon oxynitride, aluminum silicon nitride, and hafnium aluminum nitride which are matrix materials. However, the first and third layers L₁ and L₃ are not limited thereto. Each of the first and third layers L₁ and L₃ may include some components of the matrix material. For example, the first layer L₁ may include aluminum oxide, and the third layer L₃ may include aluminum nitride.

The charge trap layer 122 is shown to include three layers, but is not limited thereto. The charge trap layer 122 may include three layers, five layers, or seven layers. Matrix materials and crystallization control materials may be alternately arranged in the thickness direction of the charge trap layer 122.

The charge trap layer 122 may be divided into a plurality of layers, but the division between the layers may not be clear. In some example embodiments, even though the charge trap layer 122 includes a plurality of layers, materials of the charge trap layer 122 may be mixed with each other by heat treatment so that the charge trap layer 122 may appear as one layer.

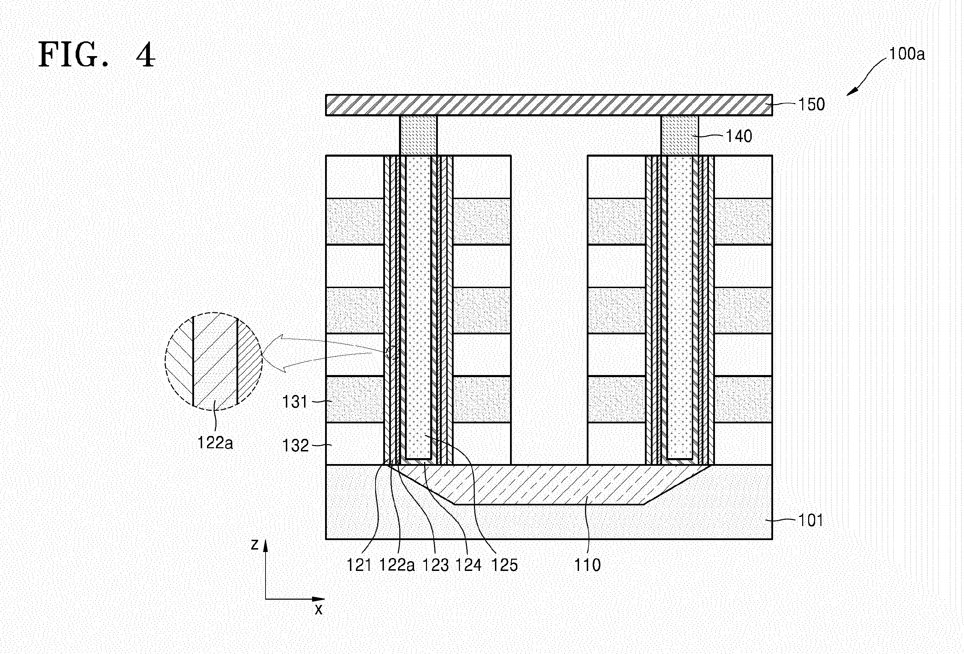

FIG. 4 is a diagram illustrating a vertical non-volatile memory device 100a including a charge trap layer 122a that appears as a single layer according to an example embodiment.

Comparing FIG. 1 and FIG. 4, the charge trap layer 122a is formed as a single layer. The charge trap layer 122a may be formed as the single layer or may be formed as a single layer by mixing materials by heat treatment after being formed as a plurality of layers.

The charge trap layer 122 may include AxByOzN (1-x-y-z) (A and B are different elements, and at least one of A or B is a metal element, O is oxygen, N is nitrogen, x≥0.3, 0<y≤0.1, z≥x). Here, the A element may be a component of a matrix material, and the B element may be a component of a crystallization control material. For example, the A element may be any one of aluminum (Al), hafnium (Hf), zirconium (Zr), and silicon (Si), and the B element may be any one of aluminum (Al), hafnium (Hf), zirconium (Zr), silicon (Si), boron (B), and gallium (Ga).

The content of A element in the charge trap layer 122 may be in a range between about 30 at% and about 40 at%. In some example embodiments, the content of A element in the charge trap layer 122 may be about 30at%, about 31 at%, about 32 at%, about 33 at%, about 34 at%, about 35 at%, about 37 at%, about 38 at%, about 39 at %, or about 40at%. The content of B element may be greater than 0 at% and less than about 10 at%. In some example embodiments, the content of B element may be about 1 at%, about 2 at%, about 3 at%, about 4 at%, about 5 at%, about 6 at%, about 7 at%, about 8 at%, about 9 at%, or about 10 at%. The content of oxygen element may be equal to or greater than the content of A element. The content of oxygen element may be in a range between about 30 at% and 60 at%. In some example embodiments, the content of oxygen element may be about 30 at%, about 35 at%, about 45 at%, about 50 at%, about 55 at%, or about 60 at%.

The charge trap layer 122 may further include carbon. For example, the charge trap layer 122 may include AxByOzCwN (1-x-y-z-w) (A and B are different elements, and at least one of A or B is a metal element, O is oxygen, N is nitrogen, x≥0.3, 0< y≤0.1, z≥x, 0<w≤y). Here, the A element may be a component of a matrix material, and the B element may be a component of a crystallization control material. For example, the A element may be any one of aluminum (Al), hafnium (Hf), zirconium (Zr), and silicon (Si), and the B element may be any one of aluminum (Al), hafnium (Hf), zirconium (Zr), silicon (Si), boron (B), and gallium (Ga).

The content of A element in the charge trap layer 122 may be in a range between about 30 at% and about 40 at%. In some example embodiments, the content of A element in the charge trap layer 122 may be about 30 at%, about 31 at%, about 32 at%, about 33 at%, about 34 at%, about 35 at%, about 37 at%, about 38 at%, about 39 at %, or about 40at%. The content of B element may be greater than 0 at% and equal to or less that about 10 at%. In some example embodiments, the content of B element may be 1 at%, 2 at%, 3 at%, 4 at%, 5 at%, 6 at%, 7 at%, 8 at%, 9 at%, or 10 at%. The content of oxygen element may be equal to or greater than the content of A element. The content of oxygen element may be in a range between about 30 at% and about 60 at%. In some example embodiments, the content of oxygen element may be about 30 at%, about 35 at%, about 45 at%, about 50 at%, about 55 at , or about 60 at%. The content of carbon element may be less than or equal to the content of nitrogen element. For example, the content of carbon element may be greater than 0 at% and equal to or less than about 10 at%. In some example embodiments, the content of carbon element may be 1 at%, 2 at%, 3 at%, 4 at%, 5 at%, 6 at%, 7 at%, 8 at%, 9 at%, or 10 at%.

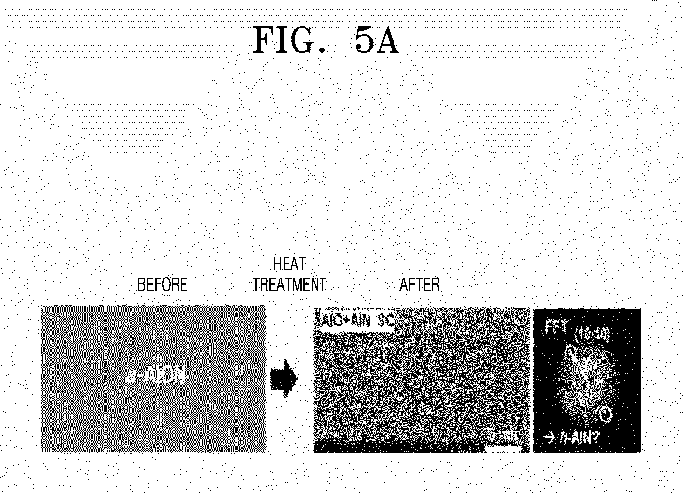

FIG. 5A is a diagram showing an image and a Fourier transform pattern obtained by forming a charge trap layer including aluminum oxynitride and then analyzing a result of heat treatment thereon using a transmission electron microscope, according to a comparative example.

When aluminum oxynitride is formed at below about 400 °C, the aluminum oxynitride may be an amorphous phase. When the charge trap layer is formed using aluminum oxynitride, trap density may be improved compared to forming the charge trap layer using silicon nitride. However, as shown in FIG. 5A, when heat treatment is performed, for example, at about 1000 °C or higher, nanometer-sized h-AlN crystals may be formed. The crystals have a problem of lowering the trap density.

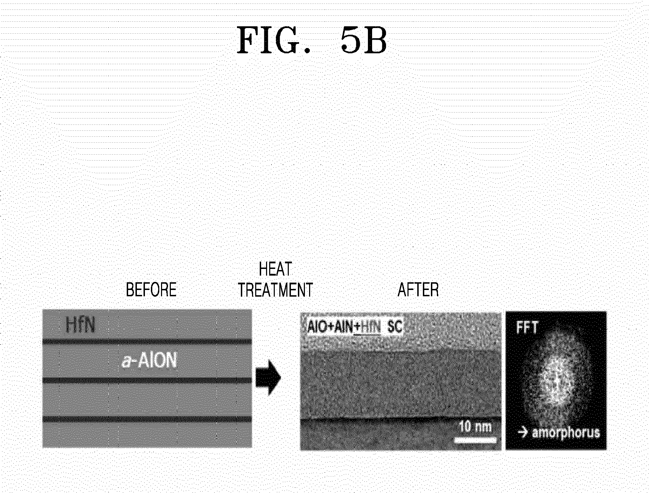

FIG. 5B is a diagram showing an image and a Fourier transform pattern obtained by forming a charge trap layer including aluminum oxynitride and hafnium nitride and then analyzing a result of heat treatment thereon using a transmission electron microscope.

Formation of aluminum oxynitride at about 400°C may be an amorphous phase. Aluminum oxynitride is formed, and hafnium nitride is formed as an insertion layer. For example, an aluminum oxynitride layer and a hafnium nitride layer are alternately formed. The content of aluminum nitride is 90 at% or more, and the content of hafnium nitride is about 10 at% or less. As shown in FIG. 5B, it may be confirmed that crystallization is not formed in aluminum oxynitride even when heat is applied to the charge trap layer. It may be confirmed that hafnium nitride suppresses the crystallization of aluminum oxynitride so that aluminum oxynitride maintains the amorphous phase.

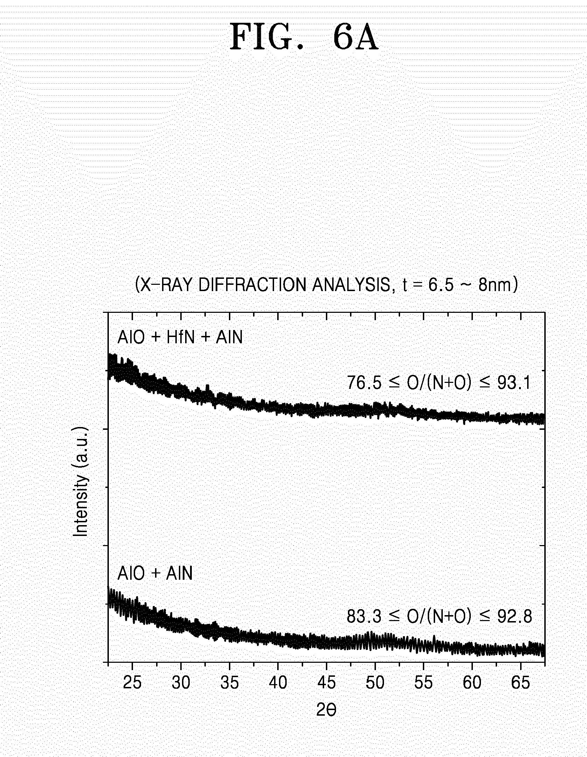

FIG. 6A is a graph showing X-ray diffraction analysis according to a material of a charge trap layer at a relatively small thickness according to an example embodiment. The charge trap layer of the comparative example is formed by alternately forming aluminum oxide and aluminum nitride through an atomic layer deposition process and then heat-treated. The content of oxygen relative to the sum of nitrogen and oxygen in the charge trap layer 122 of the comparative example is in a range of about 83.3 at% to about 92.8 at%.

The charge trap layer of an example embodiment is formed by sequentially forming aluminum oxide, hafnium nitride, and aluminum nitride through an atomic layer deposition process and then heat-treated. The content of oxygen relative to the sum of nitrogen and oxygen in the charge trap layer of the example embodiment is in a range of about 76.5 at% to about 93.1 at%.

When the thickness of the charge trap layer is about 10 nm or less, the scattering intensity of the charge trap layer including hafnium nitride is greater than the scattering intensity of the charge trap layer without hafnium nitride, and no diffraction pattern is observed with respect to a crystalline phase. That is, when the thickness of the charge trap layer is small, even though no crystallization control material is included, there may be no crystalline phase or the ratio of the crystalline phase may be small. However, there is a problem in that a trap site is small because the thickness of the charge trap layer is small.

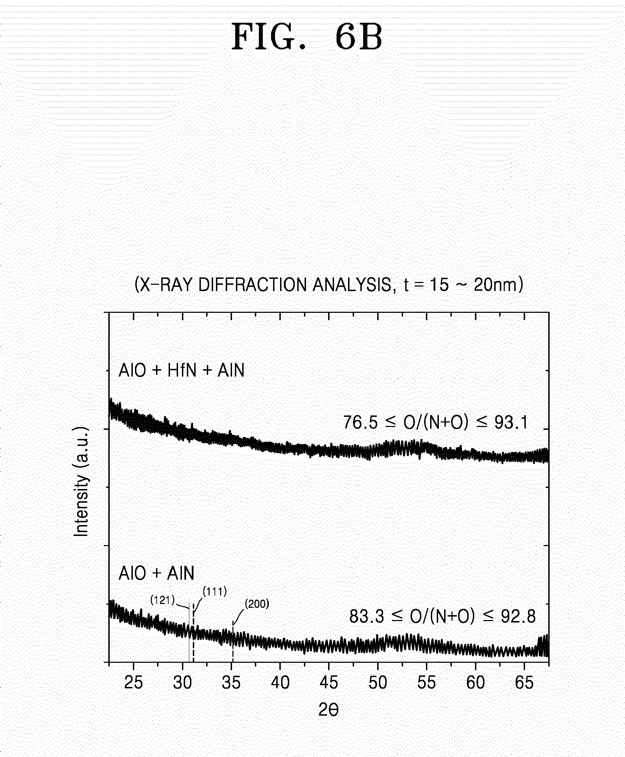

FIG. 6B is a graph showing X-ray diffraction analysis according to a material of a charge trap layer at a relatively great thickness according to an example embodiment. Comparing FIGS. 6A and 6B, the charge trap layer is deposited to a thickness of about 15 nm to about 20 nm and then heat treated. It may be confirmed that crystal structures such as (121), (111) and (200) are found in the charge trap layer of a comparative example. This means that the comparative example has a crystalline phase by heat treatment. However, it may be confirmed that no diffraction pattern representing the crystalline phase is found in the charge trap layer of the example embodiment and the charge trap layer maintains the amorphous phase.

When the crystallization control material is added to the charge trap layer, crystallization of the charge trap layer may be suppressed, and thus, the thickness of the charge trap layer may be maintained within a certain range. In addition, the crystallization control material may increase the trap site and increase the permittivity of the charge trap layer. According to an example embodiment, the thickness of the charge trap layer may be in a range between about 10 nm and about 30 nm. In some example embodiments, the thickness of the charge trap layer may be about 10 nm, about 15 nm, about 20 nm, about 25, or about 30 nm. Also, the permittivity of the charge trap layer may be in a range between about 9 and about 20. In some example embodiments, the permittivity of the charge trap layer may be about 9, about 12, or about 20.

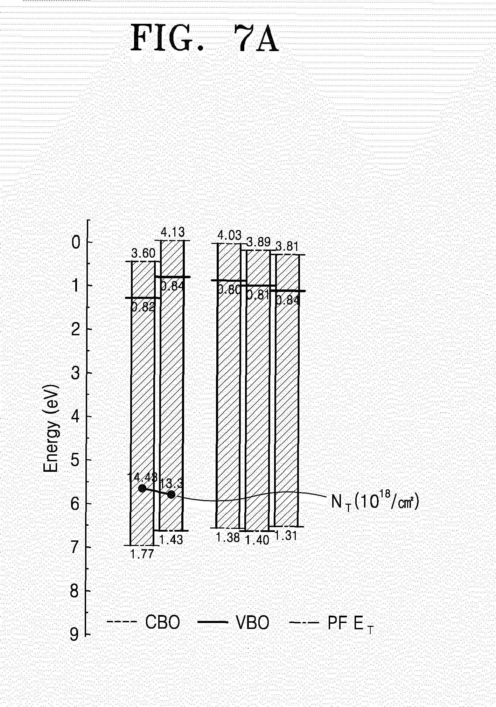

FIG. 7A is a graph showing an energy band when a charge trap layer includes silicon oxynitride according to a comparative example.

When the content of oxide relative to oxynitride is about 83 at% to about 93 at%, a valence band offset (VBO) is about 2.37 eV to about 2.46 eV, a Poole-Frenkel energy is about 1.61 eV to about 1.83 eV, and a conduction band offset (CBO) is about 2.66 eV to about 2.96 eV.

It may be seen that trap energy/density is 2.55×10¹⁸/cm² to 16.74×10¹⁸/cm², and a variation is large in the manufacturing process.

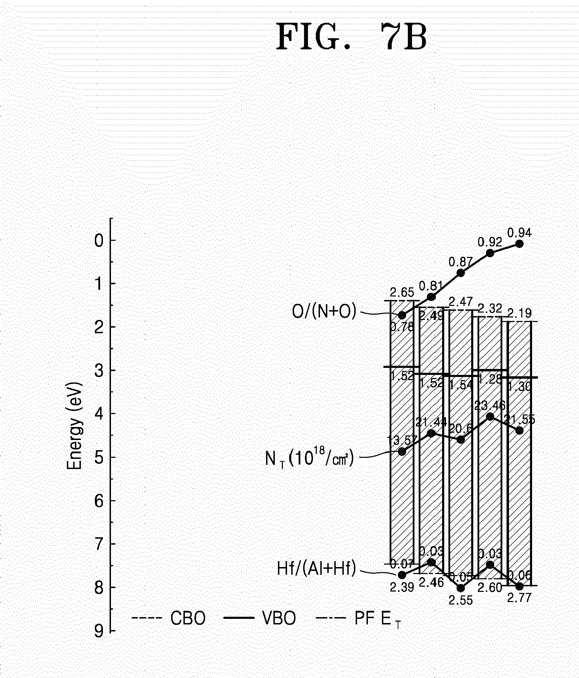

FIG. 7B is a graph showing an energy band when a charge trap layer includes hafnium nitride in addition to silicon oxynitride according to an example embodiment. The content of hafnium relative to the sum of aluminum and hafnium is about 5 at% to about 8 at%, and the content of oxide relative to oxynitride is about 75 at% to about 94 at%.

The VBO is about 2.29 eV to about 2.77 eV, the Poole-Frenkel energy is about 1.28 eV to about 1.52 eV, and the CBO is about 2.19 eV to about 2.65 eV. It may be confirmed that trap energy/density is 18.97×10¹⁸/cm² to 23.46×10¹⁸/cm², and the variation during the manufacturing process is reduced. It may be confirmed that when hafnium nitride is added, the CBO decreases and the trap density increases (0.2 eV to 0.9 eV) compared to aluminum oxynitride.

The decrease in the CBO means an increase in a barrier at the interface between the charge tunneling layer 123 and the charge trap layer 122, which means that vertical charge tunneling/emission decreases, and the depth of a charge trap site increases. Therefore, lateral charge spreading may be reduced. Further, the trap site resulting from hafnium may increase and the trap density may be improved.

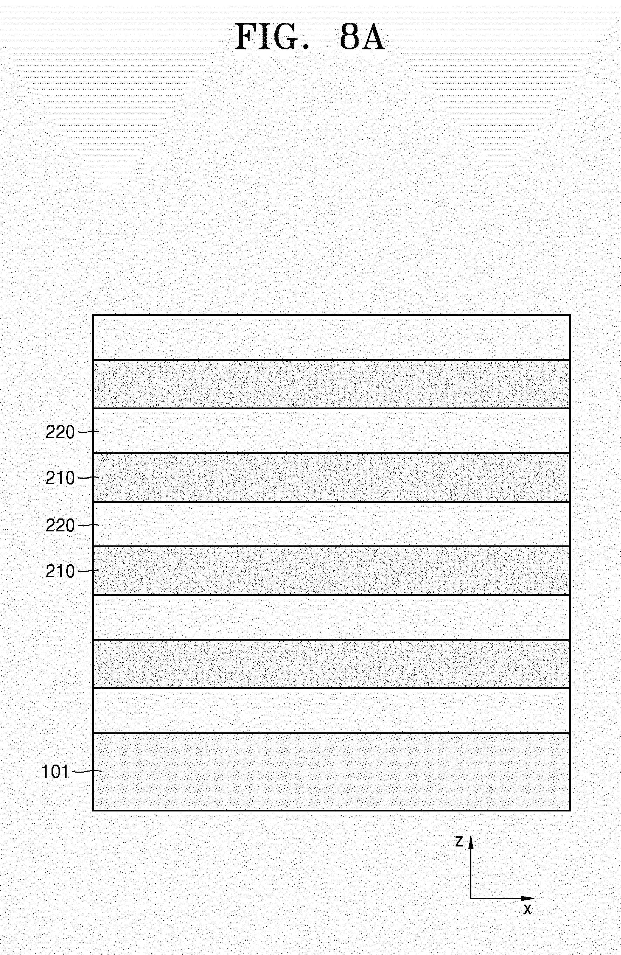

FIGS. 8A to 8G are reference views illustrating a method of manufacturing a vertical non-volatile memory device 100 according to an example embodiment.

As shown in FIG. 8A, a first insulating material layer 210 and a second insulating material layer 220 may be alternately stacked on the substrate 101. The first insulating material layer 210 and the second insulating material layer 220 may be alternately stacked in a direction perpendicular to the surface of the substrate 101. The first and second insulating material layers 210 and 220 may include different materials. The first and second insulating material layers 210 and 220 may include, for example, silicon oxide and silicon nitride, respectively, but are not limited thereto.

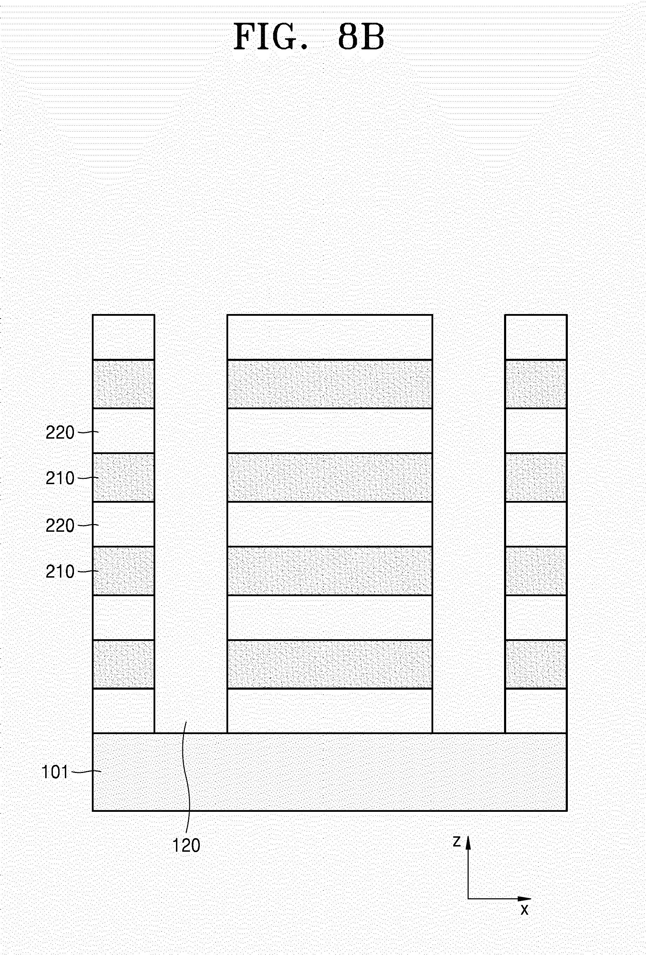

As shown in FIG. 8B, the channel hole 120 is formed to pass through each of the first and second insulating material layers 210 and 220. Here, the channel hole 120 may be formed to extend in a direction perpendicular to the surface of the substrate 101. The channel hole 120 may be formed to have a circular cross section. The channel hole 120 may be formed by anisotropically etching the first insulating material layer 210 and the second insulating material layer 220. The surface of the substrate 101 may be exposed through the channel hole 120.

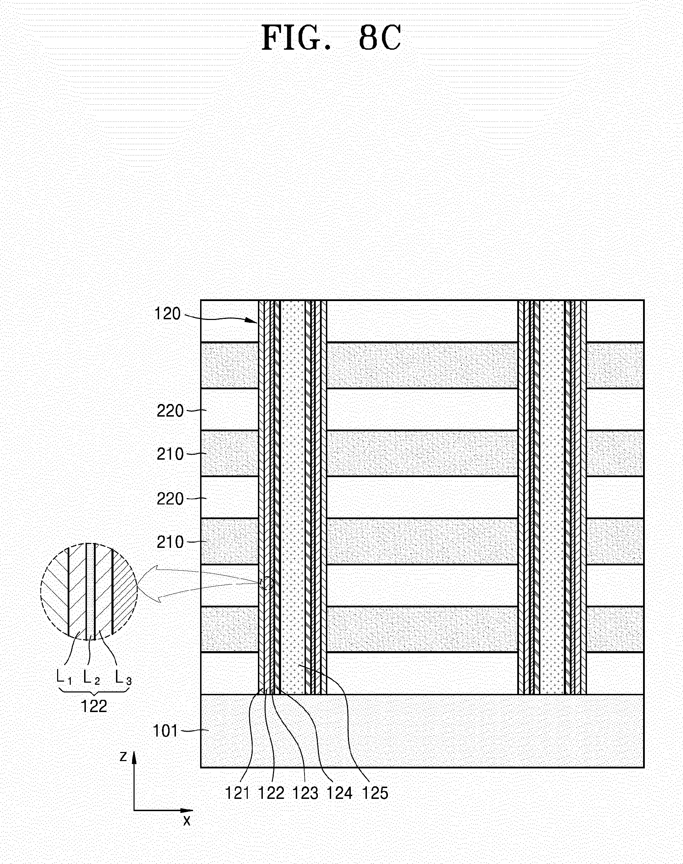

As shown in FIG. 8C, the charge blocking layer 121, the charge trap layer 122, the charge tunneling layer 123, the channel layer 124, and the pillar 125 may be sequentially formed on the inner wall of the channel hole 120.

The charge blocking layer 121 may be formed to extend in a direction perpendicular to the surface of the substrate 101. The charge blocking layer 121 may be formed on the inner wall of the channel hole 120 to contact the first and second insulating material layers 210 and 220. The charge trap layer 122 may be formed in contact with the inner side surface of the charge blocking layer 121, and the charge tunneling layer 123 may be formed in contact with the inner side surface of the charge trap layer 122. Also, the channel layer 124 may be formed in contact with an inner side surface of the charge tunneling layer 123, and the pillar 125 may be further formed in the channel layer 124. The pillar 125 is formed in FIG. 8C, but is not limited thereto. The pillar 125 may also be formed together with the formation of the gate electrode 131 to be described below.

For example, the charge trap layer 122 may include a material having a high permittivity and a high trap density. The charge trap layer 122 may include a quaternary or higher material. For example, the charge trap layer 122 may include a matrix material having a high trap density and a crystallization control material controlling crystallization of the matrix material. The content of the matrix material in the charge trap layer 122 may be dominant as 80 at% or more, 85 at% or more, 90 at% or more, or 95 at% or more. The content of the crystallization control material in the charge trap layer 122 may be 20 at% or less, 15 at% or less, 10 at% or less, or 5 at% or less.

The matrix material may include oxynitride. For example, the matrix material may include at least one of aluminum oxynitride or silicon oxynitride. The matrix material may include oxide as well as nitride, and may implement low formation energy and deep trap charge state while having an intrinsic defect due to nitrogen vacancy.

The crystallization control material may include at least one of hafnium nitride, aluminum nitride, boron nitride, gallium nitride, silicon oxide, aluminum oxide, magnesium oxide, zirconium carbide, hafnium carbide, silicon carbide, or aluminum carbide.

The charge trap layer 122 may include the first layer L₁ constituting the matrix material, the second layer L₂ constituting the crystallization control material, and the third layer L₃ constituting the matrix material. The first to third layers L₁, L₂, and L₃ may be sequentially formed from the charge blocking layer 121. That is, the first layer L₁ may be formed inside the side surface of the charge blocking layer 121, the second layer L₂ may be formed inside the side surface of the first layer L₁, and the third layer L₃ may be formed inside the side surface of the second layer L₂.

The first and third layers L₁ and L₃ may include the same material or different materials. For example, the first and third layers L₁ and L₃ may include at least one of aluminum oxynitride, silicon oxynitride, aluminum silicon nitride, and hafnium aluminum nitride which are matrix materials. However, the first and third layers L₁ and L₃ are not limited thereto. Each of the first and third layers L₁ and L₃ may include some components of the matrix material. For example, the first layer L₁ may include aluminum oxide, and the third layer L₃ may include aluminum nitride.

Although not shown in the drawing, the multi-layer structure of the first to third layers L₁, L₂, and L₃ included in the charge trap layer 122 may be maintained, but materials included in the first to third layers L₁, L₂, and L₃ may be mixed by heat treatment.

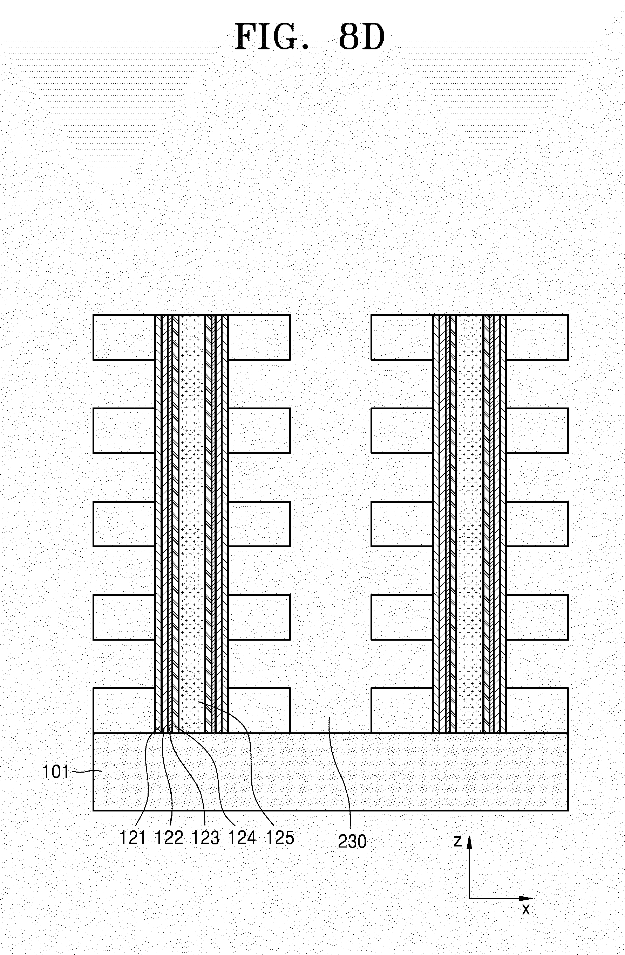

As shown in FIG. 8D, an opening 230 penetrating the first and second insulating material layers 210 and 220 may be formed, the charge blocking layer 121 may be exposed by removing the first insulating material layer 210. The first insulating material layer 210 may be etched by a wet etching process.

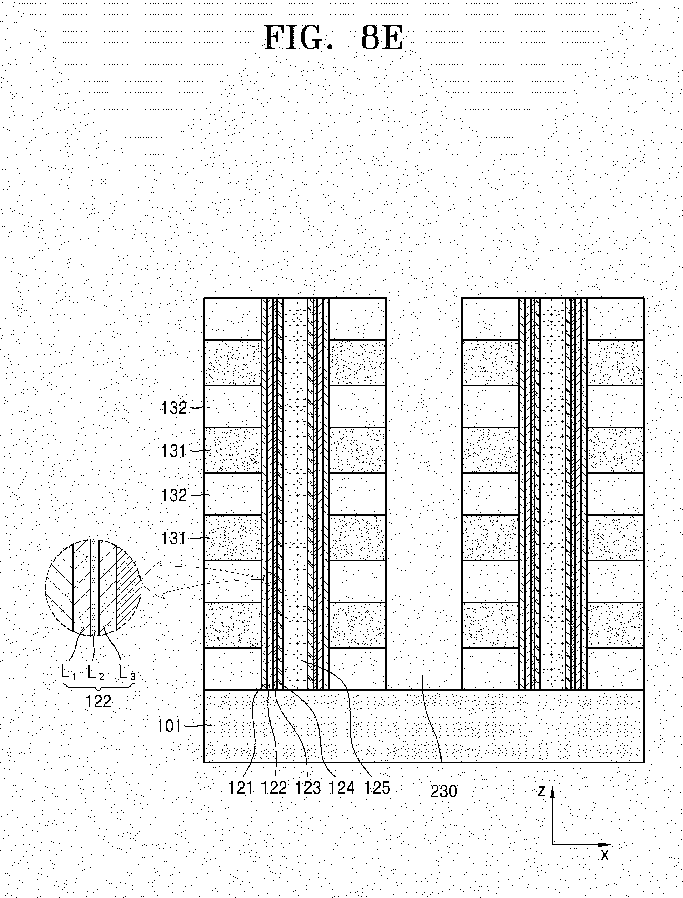

As shown in FIG. 8E, a gate electrode 131 may be formed in a region where the first insulating material layer 210 is removed. When the gate electrode 131 is formed, the pillar 125 may also be formed. The remaining second insulating material layer 220 may become the separation layer 132. 220

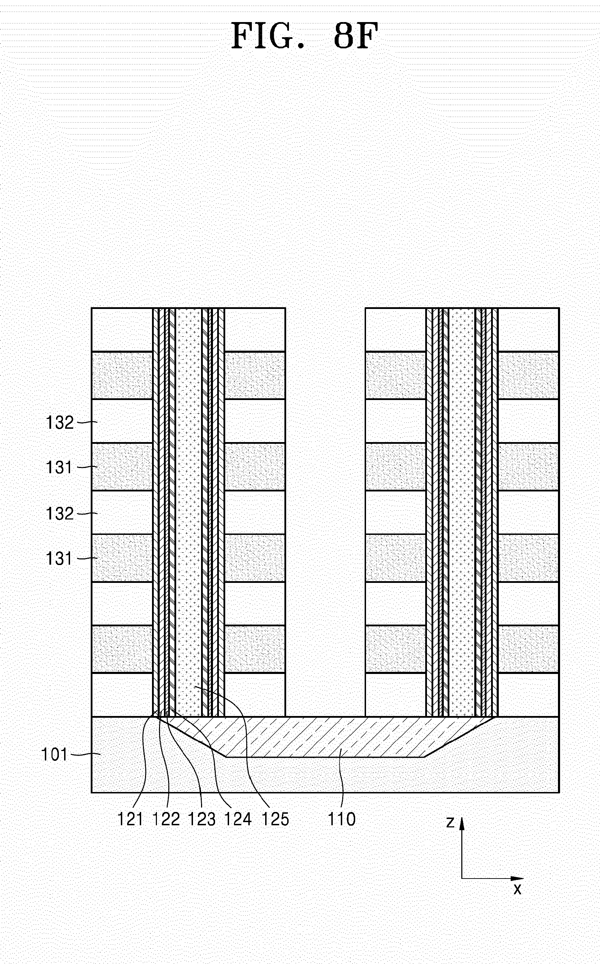

As shown in FIG. 8F, the common source region 110 may be formed on the substrate 101 exposed by the opening 230. The common source region 110 may be formed by doping an n-type impurity such as phosphorus (P).

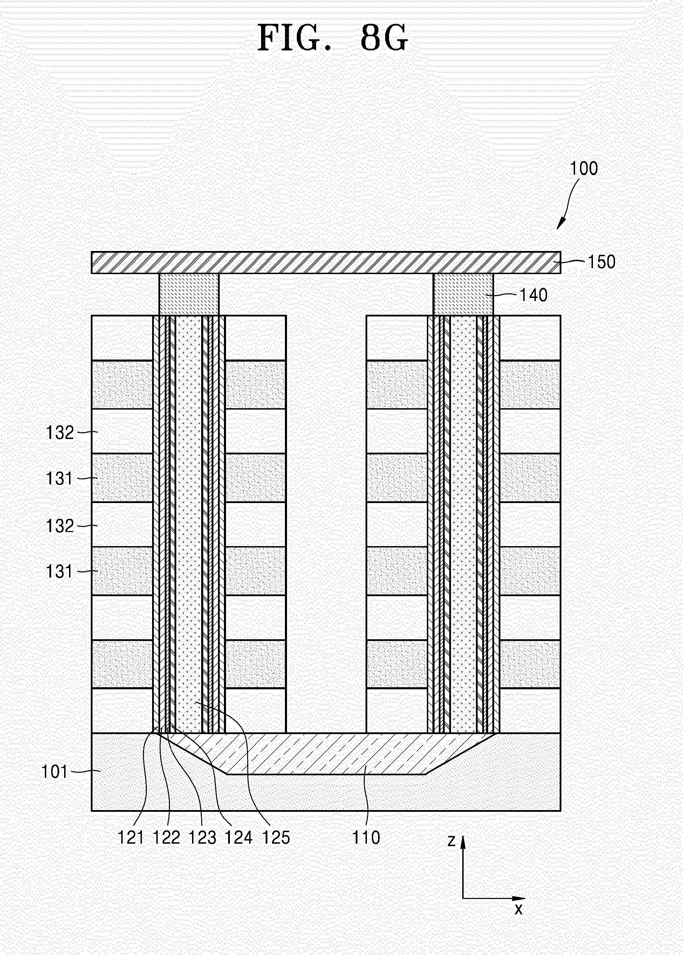

As shown in FIG. 8G, the drain 140 may be formed on the charge trap layer 122 and the bit line 150 may be formed on the drain 140.

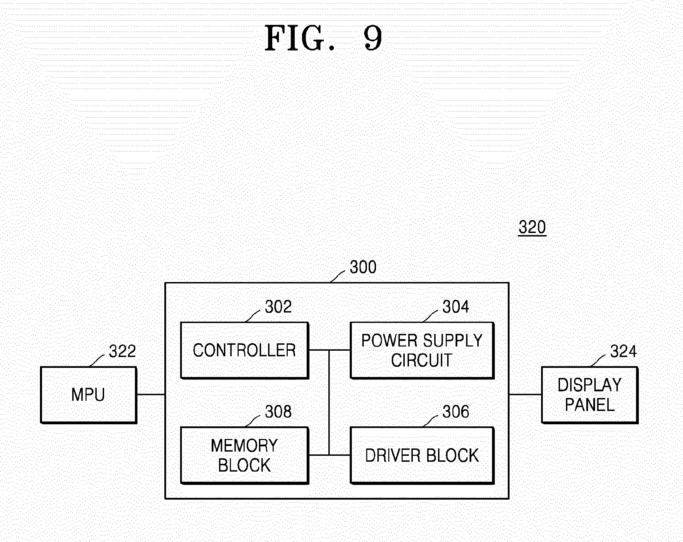

FIG. 9 is a schematic block diagram illustrating a display driver IC (DDI) 300 and a display apparatus 320 including the DDI 300 according to an example embodiment. Referring to FIG. 9, the DDI 300 may include a controller 302, a power supply circuit 304, a driver block 306, and a memory block 308. The controller 302 may receive and decode a command applied from a main processing unit (MPU) 322 and control each of the blocks of the DDI 300 to implement an operation according to the command. The power supply circuit 304 may generate a driving voltage in response to control by the controller 302. The driver block 306 may drive a display panel 324 by using the driving voltage generated by the power supply circuit 304 in response to the control by the controller 302. The display panel 324 may be, for example, a liquid crystal display panel, an organic light emitting device (OLED) display panel, or a plasma display panel. The memory block 308 may be a block for temporarily storing commands input to the controller 302 or control signals output from the controller 302 or storing desired data and may include a memory such as a RAM and/or a ROM. For example, the memory block 308 may include the memory device 100 or 100a according to the above example embodiments.

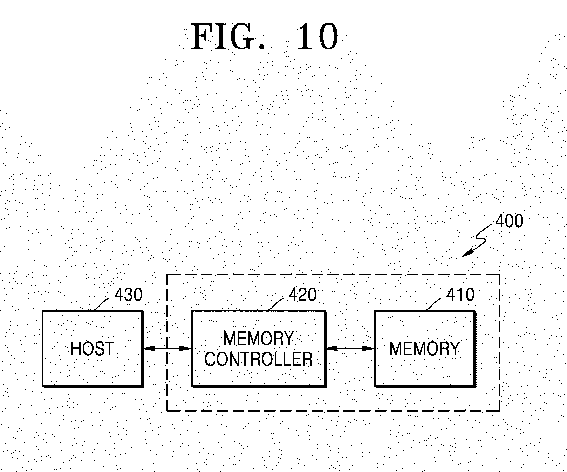

FIG. 10 is a block diagram illustrating an electronic apparatus 400 according to an example embodiment. Referring to FIG. 10, the electronic apparatus 400 may include a memory 410 and a memory controller 420. The memory controller 420 may control the memory 410 to read data from the memory 410 and/or write data into the memory 410 in response to a request from a host 430. The memory 410 may include the memory device 100 or 100a according to the above example embodiments.

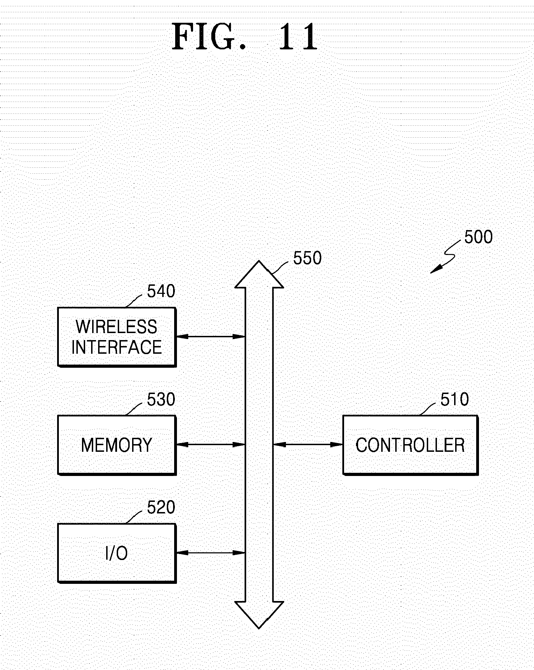

FIG. 11 is a block diagram illustrating an electronic apparatus 500 according to an example embodiment. Referring to FIG. 11, the electronic apparatus 500 may configure a wireless communication apparatus or an apparatus capable of transmitting and/or receiving information in a wireless environment. The electronic apparatus 500 may include a controller 510, an input/output (I/O) device 520, a memory 530, and a wireless interface 540, which may be connected to each other through a bus 550.

The controller 510 may include at least one of a microprocessor, a digital signal processor, and any similar processing device. The I/O device 520 may include at least one of a keypad, a keyboard, and a display. The memory 530 may be used to store a command executed by the controller 510. For example, the memory 530 may be used to store user data. The electronic apparatus 500 may use the wireless interface 540 to transmit/receive data through a wireless communication network. The wireless interface 540 may include an antenna and/or a wireless transceiver. In some embodiments, the electronic apparatus 500 may be used in the communication interface protocols of third-generation communication systems such as Code Division Multiple Access (CDMA), Global System for Mobile Communications (GSM), North American Digital Cellular (NADC), Extended Time Division Multiple Access (E-TDMA), and/or Wideband Code Division Multiple Access (WCDMA). The memory 530 of the electronic apparatus 500 may include the memory device 100 or 100a according to the above example embodiments.

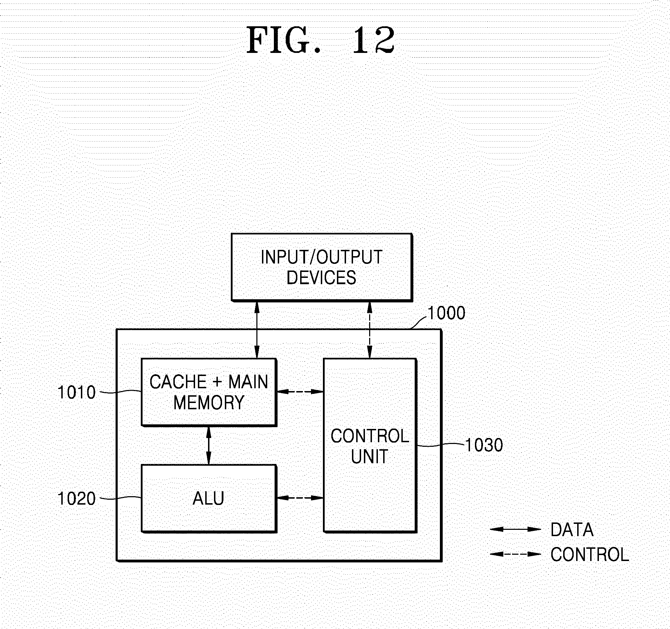

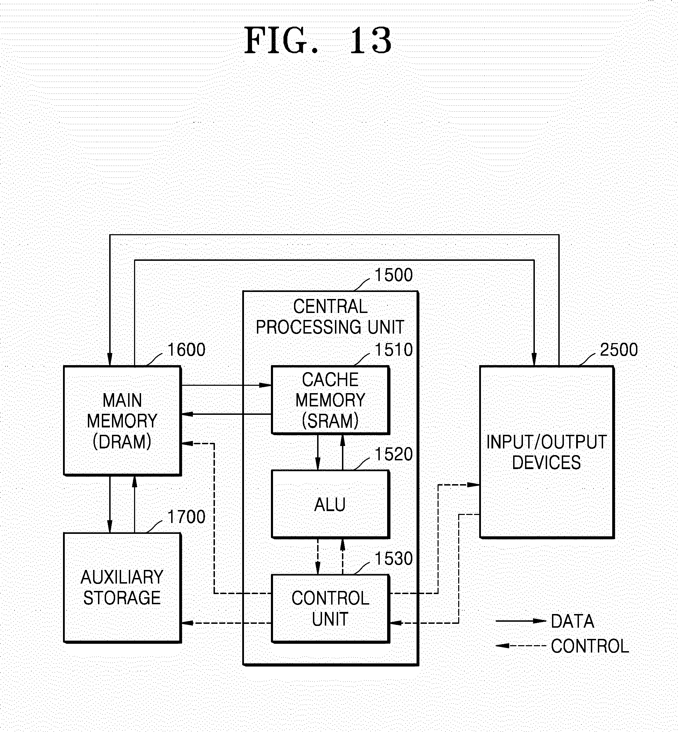

FIGS. 12 and 13 are conceptual diagrams schematically illustrating device architectures applicable to an electronic apparatus according to some example embodiments.

Referring to FIG. 12, an electronic device architecture 1000 may include a memory unit 1010 and a control unit 1030 and may further include an arithmetic logic unit (ALU) 1020. The memory unit 1010, the ALU 1020, and the control unit 1030 may be electrically connected to each other. For example, the electronic device architecture 1000 may be implemented as a single chip including the memory unit 1010, the ALU 1020, and the control unit 1030. In some example embodiments, the memory unit 1010, the ALU 1020, and the control unit 1030 may be connected to each other through a metal line on-chip to directly communicate with each other. The memory unit 1010, the ALU 1020, and the control unit 1030 may be monolithically integrated on one substrate 101 to constitute one chip. An input/output device 2000 may be connected to the electronic device architecture (chip) 1000. Also, the memory unit 1010 may include both a main memory and a cache memory. This electronic device architecture (chip) 1000 may be an on-chip memory processing unit. Each of the memory unit 1010, the ALU 1020, and/or the control unit 1030 may independently include the variable resistance memory device 100 or 100a according to the above example embodiments.

Referring to FIG. 13, a cache memory 1510, an ALU 1520, and a control unit 1530 may constitute a central processing unit (CPU) 1500, and the cache memory 1510 may include a static random access memory (SRAM). Separately from the CPU 1500, a main memory 1600 and an auxiliary storage 1700 may be provided and an input/output device 2500 may also be provided. The main memory 1600 may be, for example, a dynamic random access memory (DRAM) and may include the memory device 100 or 100a according to the above example embodiments.

In some cases, the electronic device architecture may be implemented in a form in which computing unit devices and memory unit devices are adjacent to each other in one chip without distinction between subunits.

The vertical non-volatile memory devices 100 and 100a and the apparatus including the same described above have been described with reference to some example embodiments shown in the drawings, but these are merely examples, and it will be understood by those of ordinary skill in the art that various modifications and other equivalent example embodiments are possible therefrom. Although many matters have been specifically described above, they should be construed as examples of specific example embodiments rather than limiting the scope of the disclosure. Therefore, the scope of the disclosure should not be defined by the described example embodiments, but should be defined by the technical ideas described in the claims.

The above-described vertical nonvolatile memory device may increase the trap density and increase the permittivity of the charge trap layer.

The aforementioned vertical nonvolatile memory device may reduce charge diffusion between cells.

The vertical non-volatile memory device described above is easy to implement low power consumption and high integration.

Any functional blocks shown in the figures and described above may be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within each example embodiment should typically be considered as available for other similar features or aspects in other example embodiments. While some example embodiments have been described with reference to the figures, it will be understood by those of ordinary skill in the art that various changes in form and details may be made therein without departing from the scope as defined by the following claims.

## Claims

1. A vertical non-volatile memory device comprising:
a pillar;
a channel layer surrounding a side surface of the pillar;
a charge tunneling layer surrounding a side surface of the channel layer;
a charge trap layer surrounding a side surface of the charge tunneling layer and comprising an amorphous oxynitride;
a charge blocking layer surrounding a side surface of the charge trap layer; and
a plurality of separation layers and a plurality of gate electrodes surrounding a side surface of the charge blocking layer and alternately arranged along the side surface of the charge blocking layer.

2. The vertical non-volatile memory device of claim 1, wherein the charge trap layer includes AxByOzN (1-x-y-z) (A and B are different elements, and at least one of A or B is a metal element, O is oxygen, N is nitrogen, x≥0.3, 0<y≤0.1, z≥x), and optionally wherein the A element is any one of aluminum (Al), hafnium (Hf), zirconium (Zr), and silicon (Si), and optionally wherein the B element is any one of aluminum (Al), hafnium (Hf), zirconium (Zr), silicon (Si), boron (B), and gallium (Ga).

3. The vertical non-volatile memory device of claim 2, wherein a content of the A element in the charge trap layer is 40 at% or less.

4. The vertical non-volatile memory device of claim 2 or 3, wherein a content of the oxygen element in the charge trap layer is 60 at% or less.

5. The vertical non-volatile memory device of claim 2, 3 or 4, wherein a content of the B element in the charge trap layer is 6 at% or less.

6. The vertical non-volatile memory device of any of claims 2 to 5, wherein the charge trap layer further includes carbon, and optionally wherein a content of carbon is less than or equal to a content of nitrogen in the charge trap layer.

7. The vertical non-volatile memory device of claim 6, wherein a content of carbon in the charge trap layer is 6 at% or less.

8. The vertical non-volatile memory device of any of claims 2 to 7, wherein a density of the A element changes in a thickness direction of the charge trap layer, and optionally wherein the charge trap layer includes a region in which a density of the B element is greater than or equal to the density of the A element in the thickness direction of the charge trap layer.

9. The vertical non-volatile memory device of any of claims 2 to 8, wherein a density of the A element is greater than a density of B element at an interface of the charge trap layer in contact with the charge tunneling layer.

10. The vertical non-volatile memory device of any of claims 2 to 9, wherein a density of the A element is greater than a density of B element at an interface of the charge trap layer in contact with the charge blocking layer.

11. The vertical non-volatile memory device of any preceding claim, wherein a trap level of the charge trap layer is 1.2 eV or more.

12. The vertical non-volatile memory device of any preceding claim, wherein a trap density of the charge trap layer is in a range between 18×10¹⁸/cm² and 30×10¹⁸/cm².

13. The vertical non-volatile memory device of any preceding claim, wherein a dielectric constant of the charge trap layer is equal to or greater than 9.

14. The vertical non-volatile memory device of any preceding claim, wherein the charge trap layer includes a nanocrystal of 10 at% or less, and optionally wherein the nanocrystal has a diameter in a range between 0.5 nm and 5 nm.

15. The vertical non-volatile memory device of any preceding claim, wherein a thickness of the charge trap layer is in a range between 5 nm and 30 nm.
